# EUROPÄISCHE PATENTSCHRIFT

(11) **EP 0 592 816 B1**
(45) Veröffentlichungstag und Bekanntmachung des Hinweises auf die Patenterteilung: **13.05.1998**
(21) Anmeldenummer: 93114615.3
(22) Anmeldetag: 11.09.1993
(51) Int. Cl.: G01R 33/30

(54) **Direkt-gekoppeltes Probenwechselsystem für Flüssigkeits-NMR-Spektroskopie**
Directly coupled system for sample change for us in liquid NMR spectroscopy
Système d'échange d'échantillon pour spectroscopie RMN de liquides

(30) Priorität: 14.10.1992 DE 4234544
(43) Veröffentlichungstag der Anmeldung: 20.04.1994
(73) Patentinhaber: BRUKER ANALYTIK GMBH, 76287 Rheinstetten (DE)
(72) Erfinder: Spraul, Manfred Dr., D 7505 Ettlingen 6 (DE); Hofmann, Martin, D 7512 Rheinstetten (DE)
(74) Vertreter: KOHLER SCHMID + PARTNER

(56) Entgegenhaltungen:
- DE-A- 2 759 457
- DE-A- 4 101 473
- H. GÜNTHER 'NMR-Spektroskopie' 1983 , GEORG THIEME VERLAG , STUTTGART * Seiten 52 - 54, Kapitel 3.1 * * Abbildung 3.2 *
- ANALYTICAL CHEMISTRY Bd. 52, Nr. 7 , 1980 , COLUMBUS, USA Seiten 1135 - 1140 J.F. HAW ET AL. 'Direct Coupling of a Liquid Chromatograph to a Continuous Flow Hydrogen Nuclear Magnetic Resonance Detector for Analysis of Petroleum and Synthetic Fuels'

## Beschreibung

Die Erfindung betrifft ein Kernspinresonanz (NMR)-Spektrometer zur Messung flüssiger, insbesondere biologischer, vor allem wässriger Proben mit einem Magnetsystem zur Erzeugung eines homogenen, statischen Magnetfeldes B₀ und mit einem Probenkopf, der eine obere und eine untere Halterung, einen Anschluß für eine Zulaufleitung zum Zuführen einer flüssigen Probe in das Spektrometer und einen Anschluß für eine Ablaßleitung zum Ablassen der flüssigen Probe aus dem Spektrometer, ein zwischen der oberen und unteren Halterung angeordnetes, insbesondere zylindrisches Probenröhrchen zur Aufnahme der flüssigen Probe aufweist, wobei das eine Ende des Probenröhrchens mit dem Anschluß für die Zulaufleitung und das andere Ende mit dem Anschluß für die Ablaßleitung verbunden ist, sowie eine das Probenröhrchen umgebende Hochfrequenz (HF)-Spule zum Erzeugen und/oder Detektieren eines senkrecht zur Richtung des statischen Magnetfeldes B₀ gerichteten HF-Magnetfeldes in einem Meßvolumen im Inneren des Probenröhrchens.

Ein solches NMR-Spektrometer ist beispielsweise aus der DE 41 01 473 A1 bekannt.

Bei NMR-spektroskopischen Messungen von Flüssigkeiten wird in der Regel zunächst das flüssige Untersuchungsmaterial, das meist in einem standardisierten Gefäß transportiert und aufbewahrt wird, in ein genormtes Glasröhrchen umgefüllt, welches in den Probenkopf eines NMR-Spektrometers eingebracht werden kann. Um einen quantitativen Vergleich der Linienintensitäten verschiedener chemischer Komponenten des Untersuchungsmaterials zu ermöglichen, wird oftmals eine Standardflüssigkeit dem Untersuchungsmaterial beigemengt. Außerdem wird zur Stabilisierung des homogenen statischen Magnetfeldes (bzw. der Meßfrequenz) eine deuterierte Flüssigkeit ("Locksubstanz") beigegeben, auf deren NMR-Signale das Magnetfeld bzw. die Meßfrequenz stabilisiert ("gelockt") wird. Danach wird das genormte NMR-Glasröhrchen in einen automatischen Probenwechsler eingeführt, von wo es zu gegebener Zeit dem Probenkopf zugeführt wird, wo ein NMR-Spektrum, meist mit Unterdrückung der H₂O-Linie aufgenommen wird.

Diese beispielsweise aus dem Lehrbuch "Practical NMR Spectroscopy" von M. L. Martin et al., Heyden & Son Ltd., London 1980, speziell Seiten 365 ff bekannte Vorgehensweise hat den Nachteil, daß dem flüssigen Untersuchungsmaterial grundsätzlich eine Eichflüssigkeit bestehend aus einer Standardflüssigkeit und/oder einer deuterierten Locksubstanz beigemischt werden muß. Dies kann vor allem bei Proben aus dem medizinischen Bereich (beispielsweise Körperflüssigkeiten, Zellextrakte usw.) oder aus der Lebensmittelchemie (Weinextrakte, Milch, Honig usw.) hochgradig unerwünscht sein. Einerseits könnte die Eichflüssigkeit mit der Probenflüssigkeit chemische Reaktionen eingehen, andererseits kann beispielsweise ein Zusatz von Locksubstanz die pH-Werte des flüssigen Untersuchungsmaterials ändern und damit zu veränderten NMR-Spektren führen. Der Zusatz von D₂O zu H₂O führt weiterhin zu einer Linienverbreiterung aufgrund des Austausches zwischen Protonen und Deuteronen. Damit wird insbesondere das H₂O-Signal verbreitert, was eine Unterdrückung des in der Regel unerwünschten Wassersignals aus der Probenflüssigkeit erschwert, da eine Signalunterdrückung um so einfacher ist, je schärfer die entsprechende Linie gemessen werden kann.

Speziell bei medizinischen Proben ist der Zusatz einer Standardflüssigkeit zur Probenflüssigkeit ebenfalls kritisch, da die Inhaltsstoffe der Probenflüssigkeit den Standard komplexieren können. Dies führt wiederum zu einer Änderung der Linienbreite des Standards, was einen quantitativen Vergleich der Linienintensitäten erschwert.

Ein weiterer Nachteil der klassischen Vorgehensweise besteht darin, daß die Probenflüssigkeit nach Zugabe der Eichflüssigkeit in der Regel von der letzteren nicht mehr befreit werden kann, so daß die Probenflüssigkeit möglicherweise für weitere Untersuchungen und Tests nach der NMR-Messung nicht mehr verwendet werden kann.

Schließlich erweist es sich auch als nachteilig, daß vor jeder NMR-Messung die Flüssigkeitsprobe durch Zugabe von Locksubstanz und/oder Standardflüssigkeit erst vorbereitet werden muß, was in der Regel manuell geschieht und neben einem erheblichen Zeitverlust auch gewisse Risiken wie z.B. unsachgemäße Behandlung oder Verschütten der Probe birgt. Insbesondere bei Serienmessungen vieler gleichartiger oder ähnlicher Flüssigkeitsproben ist die oben beschriebene Vorgehensweise hinderlich und einer Automatisierung der Meßvorgänge abträglich.

Aus der DE-A 27 59 457 ist ein Probengefäß in einem Spinresonanz-Spektrometer bekannt, das rohrförmig ist, an einem Ende eine Zuleitung von Probensubstanzen oder Spülmedien und am anderen Ende eine Leitung zum Ableiten dieser Probensubstanzen oder Spülmedien aufweist. Die Leitungen zum Zuführen und Ableiten der Substanzen sind mit dem Probengefäß in der Weise verbunden, daß die Bewegungsrichtung der zugeführten Substanzen tangential zum Probengefäß verläuft, so daß die Substanzen eine Rotationsbewegung im Probengefäß ausführen.

Ähnliche Probleme wie bei den oben beschriebenen Batch-Verfahren zur NMR-Spektroskopischen Messung von Flüssigkeitsproben ergeben sich auch bei den bekannten Durchfluß-Verfahren. In der DE 41 04 075 C1 ist beispielsweise ein Verfahren und eine Vorrichtung zur gekoppelten Flüssigkeitschromatographie- und NMR-Messung offenbart, bei dem abschnittsweise gewisse Volumina von Probenflüssigkeit in der Stop-Flow-Technik dem NMR-Probenkopf zugeführt werden. Mit der dort beschriebenen Einrichtung ist jedoch keine Gemischmessung von Flüssigkeitsproben möglich, sondern die Komponenten der Probenflüssigkeit werden vor der NMR-Spektroskopischen Messung chromatographisch getrennt.

Eine kontinuierliche Durchflußzelle, mit der auch Flüssigkeitsgemische einer NMR-Messung unterzogen werden können, ist beispielsweise aus der US-A 4,775,836 bekannt, wo eine kugelförmige Meßzelle im Homogenitätszentrum eines NMR-Spektrometers beschrieben ist, durch die kontinuierlich unter Hochdruck flüssige Probensubstanz durchgeleitet wird. Ein Vorteil dieser Anordnung soll darin bestehen, daß durch die sphärische Gestaltung des Meßvolumens Artefakte aufgrund von Inhomogenitäten der magnetischen Suszeptibilität im Meßvolumen ausgeschlossen werden. Nichtsdestoweniger muß jedoch auch in diesem Falle die Locksubstanz und/oder Standardflüssigkeit der Probenflüssigkeit beigemischt werden, wenn eine Frequenz- oder Feldstabilisierung bzw. ein quantitativer Vergleich der Linienintensitäten erfolgen soll.

Das gleiche gilt für das aus der DE 41 01 473 A1 bekannte Verfahren und das zugehörige, in der Druckschrift ebenfalls beschriebene NMR-Spektrometer, das alle eingangs erwähnten gattungsbildenden Merkmale aufweist.

Zwar sind für die Anwendung in der NMR-Spektroskopie schon seit längerem auch ineinander steckbare Glasröhrchen bekannt, wobei in das eine Röhrchen die Probenflüssigkeit und in das andere eine Eichflüssigkeit eingefüllt wird und die Röhrchen dann gemeinsam in den Probenkopf des NMR-Spektrometers zur Messung eingelegt werden (siehe zum Beispiel Katalog 5/92-7 der Firma Wilmad Glass Company in Buena, N.J. 08310 USA, Seiten 28 und 29). Damit wird zwar ein Vermischen des flüssigen Untersuchungsmaterials mit anderen Stoffen aus der Eichflüssigkeit vermieden, jedoch ist der notwendige manuelle Einfüllvorgang der beiden Flüssigkeiten, das Zusammenstecken der Röhrchen und das Einbringen in das Spektrometer nach wie vor zeitraubend und birgt immer noch die Risiken eines Verschüttens oder unbeabsichtigten Vermengens der beteiligten Flüssigkeiten. Die dadurch hervorgerufene Zeitverzögerung zwischen der Entnahme einer medizinschen Probenflüssigkeit und der NMR-Messung kann gerade für die Untersuchung von empfindlichen und leicht zersetzlichen Körperflüssigkeiten sehr nachteilig sein. Außerdem besteht während der Ein- und Ausfüllvorgänge eine erhöhte Gefahr einer Kontamination der Probenflüssigkeit mit Bakterien, Luft, Schmutz etc. Durch eine unterschiedliche individuelle Behandlung der manuell vorbereiteten Probenflüssigkeiten können auch Meßfehler bei Reihenmessungen nicht mit hinreichender Sicherheit ausgeschlossen werden. Im übrigen ist bei Anwendung der bekannten Doppelröhrchen die Verwendung eines Durchfluß-Probenkopfes ausgeschlossen, d.h., mit einer Apparatur, bei der solche Doppelröhrchen eingesetzt werden können, können ausschließlich abschnittsweise Flüssigkeitsmessungen vorgenommen werden.

Aufgabe der vorliegenden Erfindung ist es demgegenüber, ein NMR-Spektrometer zur Messung flüssiger Proben der eingangs beschriebenen Art vorzustellen, bei dem die Probenflüssigkeit ohne Zusätze vermessen und nach der Messung in ihrem Ursprungszustand wiedergewonnen werden kann, wobei eine spezielle Vorbehandlung der Probe entfällt. Danach soll das erfindungsgemäße Spektrometer sowohl für Messungen im Durchfluß- als auch im Abschnittsbetrieb (stop-flow) ohne größere Umrüstarbeiten einsetzbar sein und sich insbesondere zur automatisierten Serienmessung vieler gleichartiger Flüssigkeitsproben eignen, wobei einerseits möglichst wenige oder keine manuellen Vorbereitungen der Probe erforderlich sein sollen, andererseits aber auf eine Feldstabilisierung und/oder einen quantitativen Vergleich der Linienintensitäten aufgrund einer Standardsubstanz nicht verzichtet werden soll.

Diese Aufgabe wird gemäß der vorliegenden Erfindung überraschend einfach und wirkungsvoll dadurch gelöst, daß koaxial zum Probenröhrchen ein weiteres, insbesondere ebenfalls zylindrisches Röhrchen zur Aufnahme einer Eichflüssigkeit vorgesehen ist, das an seinem einen Ende mit einem weiteren Anschluß für eine Zulaufleitung zum Zuführen der Eichflüssigkeit in das Spektrometer und an seinem anderen Ende mit einem weiteren Anschluß für eine Ablaßleitung zum Ablassen der Eichflüssigkeit aus dem Spektrometer verbunden ist.

Aufgrund des fest eingebauten koaxialen weiteren Probenröhrchens für die Eichflüssigkeit können problemlos simultan NMR-Signale von der flüssigen Probensubstanz, von der Locksubstanz und/oder von einer Standardflüssigkeit aufgenommen werden, ohne daß die Komponenten der Eichflüssigkeit mit der Probenflüssigkeit körperlich in Berührung kommen. Damit sind insbesondere auch On-Line-Serienmessungen aus Labor-Standardbehältern möglich, die zu einem großen Grade automatisiert werden können, was bei Anwendung des klassischen Doppelröhrchens unmöglich ist. Nach Abschluß einer Messung entfällt der bei den bekannten Doppelröhrchen erforderlich große manuelle Reinigungsaufwand, und sowohl die in der Regel sehr teure Eichflüssigkeit als auch die möglicherweise mit einem hohen Aufwand gewonnen Probenflüssigkeit (insbesondere bei medizinischen Anwendungen) können nahezu vollständig in ihrem Ursprungszustand wiedergewonnen werden.

Bei einer bevorzugten Ausführungsform des erfindungsgemäßen NMR-Spektrometers sind das Probenröhrchen und das weitere Röhrchen nach Art eines Doppelröhrchens ineinander geschachtelt angeordnet. Prinzipiell wäre auch eine andere räumliche Anordnung der Röhrchen relativ zueinander denkbar, jedoch garantiert die verschachtelte Anordnung eine größtmögliche Symmetrie des Meßaufbaus und eine optimale Ausnutzung des Bereiches der größten Magnetfeldhomogenität im Spektrometer.

Bei einer weiteren bevorzugten Ausführungsform umgibt die HF-Spule das äußere der beiden Röhrchen unmittelbar, was zu einer erheblichen Verbesserung des Signal-Zu-Rausch-Verhältnisses bei der NMR-Messung beiträgt.

Besonders bevorzugt ist eine Ausführungsform, bei der das weitere Röhrchen innerhalb des Probenröhrchens angeordnet ist. Dadurch wird einerseits der Füllfaktor der Meßanordnung optimiert, andererseits wird die Shimbarkeit bei Shimmen auf eine Locksubstanz verbessert, weil das Shimvolumen kleiner, achsennäher und damit besser definiert ist. Über dies wird das Signal-zu-Rausch-Verhältnis für den Lockvorgang erhöht, da das Frequenzstandard im homogensten Bereich des statischen B₀-Feldes angeordnet ist.

Vorteilhaft ist eine weitere Ausführungsform, bei der die Verbindung der Anschlüsse mit den Zulauf- bzw. Ablaßleitung lösbar gestaltet ist. Dadurch kann der Probenkopf leichter gegen einen anderen Probenkopf ausgetauscht werden.

Normalerweise wird die HF-Spule zur Messung von Protonen oder Fluorkernen ausgebildet sein. Bei bevorzugten Ausführungsformen der Erfindung sind weitere HF-Spulen vorgesehen. Dabei ist eine weitere HF-Spule für separate Messungen von NMR-Signalen aus der Eichflüssigkeit, insbesondere von darin enthaltenen Deuteriumkernen ausgebildet. Bei einer anderen Ausführungsform oder wahlweise zusätzlich kann eine weitere HF-Spule für die separate Anregung von Heterokernen ausgebildet sein. Unter Heterokernen werden in der Regel alle Kerne außer Protonen und Fluor verstanden, beispielsweise ¹³C-Kerne. Im ersteren Falle wird mit der weiteren HF-Spule ein separater Frequenz- oder Feldlock auf Deuteriumsignale, im zweiten Falle eine indirekte Heterokernbeobachtung ermöglicht.

In einer Ausführungsform der Erfindung ist das Probenröhrchen mit seiner Achse parallel zur Richtung des homogenen statischen Magentfeldes B₀ ausgerichtet und die HF-Spulen sind als Sattelspulen ausgebildet. Eine andere Möglichkeit besteht darin, das Probenröhrchen mit seiner Achse senkrecht zur Richtung des homogenen statischen Magnetfeldes auszurichten, wobei dann als HF-Spulen Solenoidspulen Anwendung finden.

Vorzugsweise sind bei dem erfindungsgemäßen NMR-Spektrometer mindestens zwei verschiedene, möglicherweise aber auch eine Vielzahl von Probenköpfen mit kompatiblen Anschlüssen vorgesehen, so daß die Probenköpfe ohne weiteres gegeneinander ausgetauscht und an die Zulauf- bzw. Ablaufleitungen angeschlossen werden können.

Besonders vorteilhaft ist eine Weiterbildung dieser Ausführungsform, bei der die Durchmesser der Probenröhrchen und auch die Durchmesser der weiteren Röhrchen bei verschiedenen Probenköpfen unterschiedlich sind. Die differenzierte Dimensionierung der Röhrchengeometrie und entsprechend der HF-Spulen ermöglicht die Bereitstellung von Probenköpfen für unterschiedliche Anwendungsbereiche. So können ausgehend von normalen Probengrößen bei medizinischen Anwendungen abgestufte Größenbereiche bis hin zu Probenköpfen für die Vermessung von Mikroproben mit minimalen Flüssigkeitsvolumina hergestellt werden.

Vor allem für die Serien- bzw. Routinemessungen einer großen Anzahl standardisierter Proben eignet sich eine Ausführungsform des erfindungsgemäßen NMR-Spektrometers, bei der eine Einrichtung zur automatischen Entnahme von Probenflüssigkeit aus einem Standardprobenfläschchen und Zuführung und Injektion der entnommenen Probenflüssigkeit in das Probenröhrchen vorgesehen ist.

Bei einer weiteren Ausführungsform ist am oder im Probenkopf ein beispielsweise optischer oder elektrischer Sensor zur Erkennung der Ankunft der Probenflüssigkeit im Probenkopf vorgesehen. Der Sensor, der beispielsweise die Fluoreszenz oder die Leitfähigkeit seiner Umgebung mißt, kann bei entsprechender Veränderung der Meßwerte die Ankunft der Probe mit Hilfe eines elektrischen Signals einem Detektor mit entsprechender Signalverarbeitungseinrichtung zuführen, der seinerseits die Information an eine größere Steuereinheit weitergeben kann, so daß eine weitgehende Automatisierung des Einfüll- und Meßvorgangs ermöglicht wird.

Um die Entsorgung der vermessenen Flüssigkeitsproben unterschiedlich behandeln zu können, sind bei einer weiteren Ausführungsform zumindest in den Ablaßleitungen ein oder mehrere Mehrwegeventile vorgesehen.

Besonders vorteilhaft ist eine Weiterbildung dieser Ausführungsform, bei der ein Fraktionssammler und mindestens ein Entsorgungsbehälter vorgesehen sind, in die alternativ aus einem Mehrwegeventil kommende Ablaßleitungen münden. Während die möglicherweise wertvollen oder wichtigen Flüssigkeitsproben zum größten Teil in dem Fraktionssammler wiedergewonnen werden können, können weniger wichtige oder wertlose Bestandteile, z.B. die unten erwähnte Transportflüssigkeit zur Förderung der Probe, einem Abfallbehälter zur weiteren Entsorgung zugeführt werden.

Besonders bevorzugt ist eine Ausführungsform, bei der eine insbesondere an die Eigenschaften der Probenflüssigkeit angepaßte Transportflüssigkeit, beispielsweise Wasser, isotonische Lösung etc. zur Förderung der Probenflüssigkeit in die Zulauf- und Ablaßleitungen vorgesehen ist.

Vorteilhaft ist auch eine Ausführungsform, bei der eine Einrichtung zum Zuführen von Inertgas in die Zulauf- und/oder Ablaßleitungen vorgesehen ist. Das Inertgas kann beispielsweise zum Trocknen des Meßsystems nach einem Meßdurchlauf oder nach einer Spülung des Systems verwendet werden.

Besonders vorteilhaft ist eine Weiterbildung, bei der die Einrichtung zum Zuführen von Inertgas so gestaltet ist, daß eine Gasblase zwischen der Probenflüssigkeit und der Transportflüssigkeit erzeugt werden kann. Damit können die beiden Flüssigkeiten räumlich getrennt werden, so daß eine möglicherweise schädliche Vermischung ausgeschlossen ist.

Zur Reinigung des Leitungssystems und des Probenröhrchens kann bei einer Ausführungsform eine Einrichtung zum Zuführen von Waschflüssigkeit in die Zulauf- und Ablaßleitungen vorgesehen sein.

Besonders wirkungsvoll entfalten sich die vorteilhaften Eigenschaften des erfindungsgemäßen NMR-Spektrometers, wenn ein Prozessor, vorzugsweise ein PC zur Steuerung der automatisch oder halbautomatisch ablaufenden Flüssigkeitstransportvorgänge vorgesehen ist. Selbstverständlich ist auch eine manuelle Zuführung der Flüssigkeiten möglich, jedoch werden die mit dem erfindungsgemäßen System ermöglichten Serienmessungen dadurch möglicherweise erschwert bzw. verlangsamt.

In den Rahmen der vorliegenden Erfindung fällt auch ein Verfahren zum Betrieb eines NMR-Spektrometers der oben näher beschriebenen Art, bei dem zunächst die Eichflüssigkeit in das weitere Röhrchen injiziert, deren NMR-Signale gemessen und anschließend, vorzugsweise automatisch rechnergesteuert, folgende Schritte ausgeführt werden:
(a) Abzug einer Probenflüssigkeit aus einem Probengeber;
(b) Transport der Probenflüssigkeit zum Probenkopf;
(c) Injektion der Probenflüssigkeit in das Probenröhrchen;
(d) Messung von NMR-Signalen der Probenflüssigkeit;
(e) ggf. Spülen zumindest eines Teils der Zulauf- und Ablaßleitung mit einer Waschflüssigkeit gleichzeitig mit Schritt (d);
(f) Ablassen der Probenflüssigkeit aus dem Probenkopf;
(g) ggf. Spülen des in Schritt (e) nicht gespülten Teils der Zulauf- und Ablaßleitungen sowie des Probenröhrchens mit der Waschflüssigkeit;
(h) ggf. Trocknen der Leitungen mit Inertgas;
(i) Widerholung der Schritte (a) bis (h) mit einer anderen Probenflüssigkeit.

Die Erfindung wird im folgenden anhand der in der Zeichnung dargestellten Ausführungsbeispiele näher beschrieben und erläutert. Die der Beschreibung und der Zeichnung zu entnehmenden Merkmale können bei anderen Ausführungsformen der Erfindung einzeln, für sich oder zu mehreren in beliebiger Kombination Anwendung finden. Es zeigen:
- Fig. 1: eine schematische Darstellung des erfindungsgemäßen NMR-Spektrometers mit Rechnersteuerung zur automatisierten Serienuntersuchung von flüssigen Proben;
- Fig. 2: a) bis h) schematische Darstellungen von verschiedenen Stufen eines möglichen Verfahrensablaufs am erfindungsgemäßen NMR-Spektrometer;
- Fig. 3: einen Längsschnitt durch wesentliche Teile des erfindungsgemäßen Durchfluß-Probenkopfes mit separater Zuführung von Eichflüssigkeit und Probenflüssigkeit;
- Fig. 4: eine schematische Seitenansicht des erfindungsgemäßen Durchfluß-Probenkopfes mit entsprechenden Zulauf- und Ablaßleitungen und HF-Spulen.

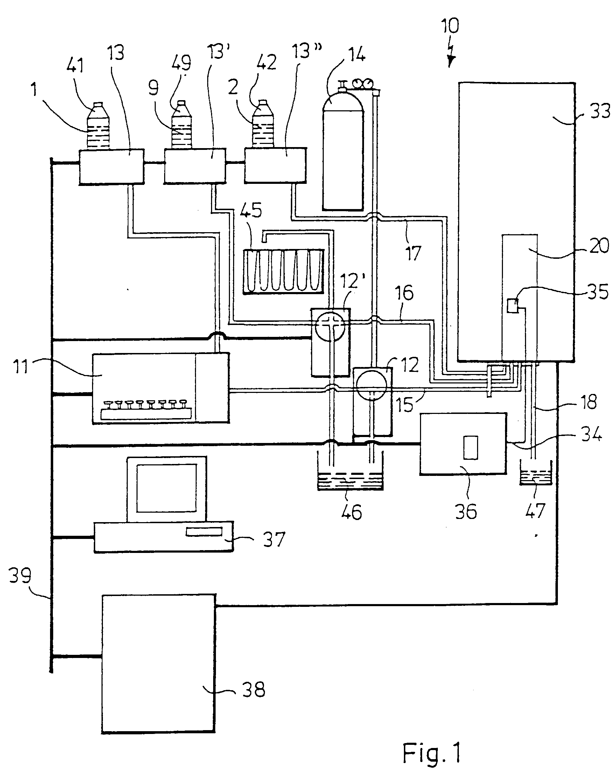

Das in Fig. 1 schematisch dargestellte Kernspinresonanz (NMR)-Spektrometer 10 zur Messung flüssiger, insbesondere biologischer Proben weist ein Magnetsystem 33 auf, mit dem innerhalb eines Meßvolumens ein homogenes, statisches Magnetfeld B₀ erzeugt wird. Im Homogenitätsbereich des Magnetfeldes B₀ befindet sich ein NMR-Probenkopf 20, in den mit Hilfe einer Pumpe 13 und einer Transportflüssigkeit 43, eine Probenflüssigkeit 1 aus einem Vorratsbehälter 41 über eine Zulaufleitung 15 eingeführt und nach der NMR-Messung über eine Ablaßleitung 16 wieder entfernt wird. Bei Serienmessungen von mehreren gleichartigen Flüssigkeitsproben erfolgt die Entnahme der jeweiligen Meßprobe in den Vorratsbehältern 41 aus einer Einrichtung 11 (Autosampler) zur automatischen Entnahme von Probenflüssigkeit 1. Über ein Mehrwegeventil 12' (hier speziell ein Vierwegeventil) kann die Probenflüssigkeit 1 nach der NMR-Messung entweder in einen Fraktionssammler 45 oder in einen Entsorgungsbehälter 46 abgelassen werden.

Zum Zwecke der Magnetfeldstabilisierung ("Feldlock") bzw. Frequenzstabilisierung der NMR-Meßfrequenz ("Frequenzlock") wird gleichzeitig mit der Probenflüssigkeit 1 eine Eichflüssigkeit 2, die eine in der Regel deuterierte Locksubstanz enthält, dem Probenkopf 20 des Spektrometers 10 zugeführt. In der Eichflüssigkeit 2 kann sich außerdem eine Standardflüssigkeit für den quantitativen Vergleich der gemessenen NMR-Linienintensitäten befinden. Die Eichflüssigkeit 2 wird aus einem Vorratsbehälter 42 durch eine Pumpe 13'' über eine Zulaufleitung 17 in den Probenkopf 20 gefördert und nach einer oder mehreren NMR-Messungen über eine Ablaßleitung 18 in einen Sammelbehälter 47 abgelassen.

Die Eichflüssigkeit 2 kann selbstverständlich auch manuell dem Probenkopf 20 zugeführt werden, da sie in der Regel für eine größere Anzahl von Messungen verschiedener Flüssigkeitsproben im Meßsystem verbleibt. Um eine bessere Mittelung über inhomogenitäten der Eichflüssigkeit zu erreichen, ist es aber auch möglich, den Sammelbehälter 47 mit dem Vorratsbehälter 42 zu verbinden und die Eichflüssigkeit 2 mit Hilfe der Pumpe 13" in einem geschlossenen Kreislauf umzupumpen.

Weiterhin ist in dem in Fig. 1 dargestellten System eine Waschflüssigkeit 9 in einem Vorratsbehälter 49 vorgesehen, die mit Hilfe einer Pumpe 13' über das Dreiwegeventil 12' in die Ablaßleitung 16 durch den Probenpfad im Probenkopf 20 in die Zulaufleitung 15 gefördert werden kann, um das System nach Abschluß der Messung einer Flüssigkeitsprobe von deren Rückständen zu reinigen. Anschließend kann Inertgas von einer Inertgaszuführung 14 über das Mehrwegeventil 12 in das Leitungssystem eingeleitet werden um dieses zu trocknen und für die nächste Messung einer Flüssigkeitsprobe vorzubereiten.

Die Steuerung der oben beschriebenen Vorgänge erfolgt im gezeigten Beispiel rechnergesteuert über einen PC 37, der über Systemvernetzungskabel 39 einerseits mit einer NMR-Konsole 38 und andererseits mit dem Autosampler 11, den Pumpen 13, 13', 13'', den Mehrwegeventilen 12, 12' sowie einem Detektor 36 verbunden ist, der über eine Sensorleitung 34 von einem am oder im Probenkopf 20 angebrachten Sensor 35 ein Signal erhält, welches die Ankunft von Probenflüssigkeit 1 im Meßkopf 20 anzeigt. Mit Hilfe des Computers 37 können daher beispielsweise in der unten näher beschriebenen Weise ganze Meßserien von Flüssigkeitsproben mit zwischengeschaltenen Reinigungsschritten vollautomatisch durchgeführt werden.

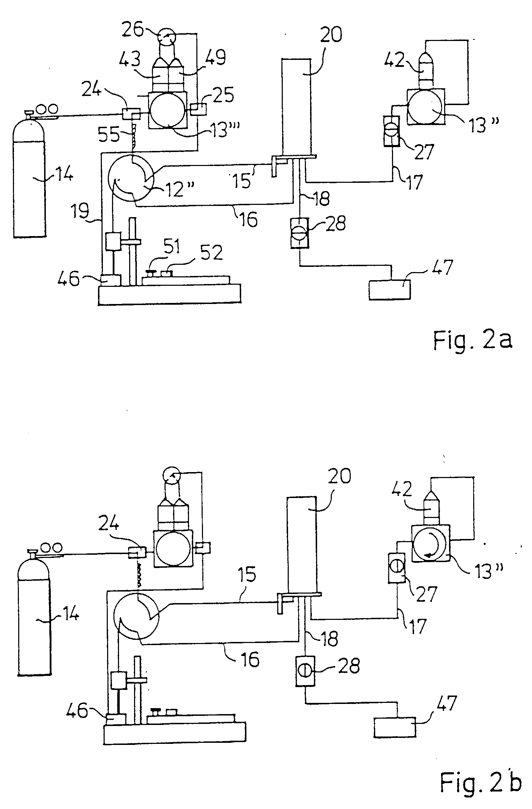

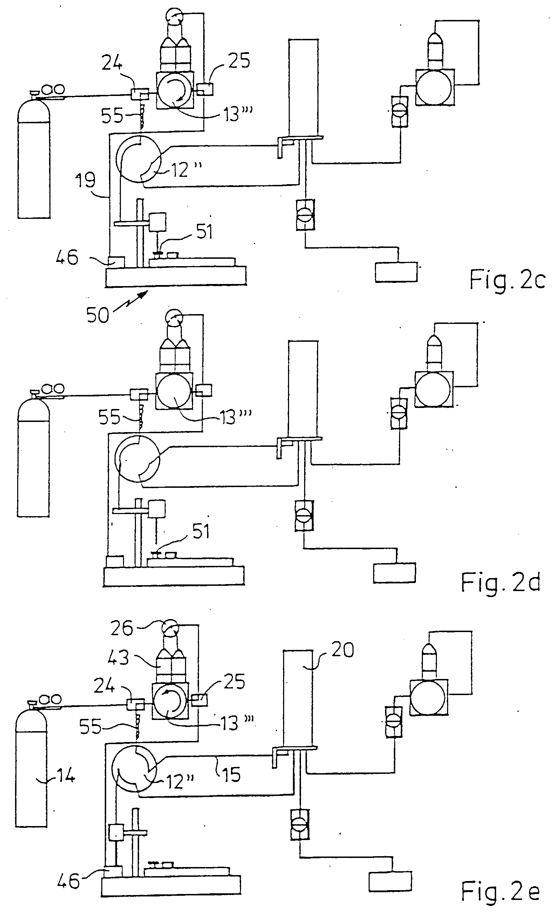

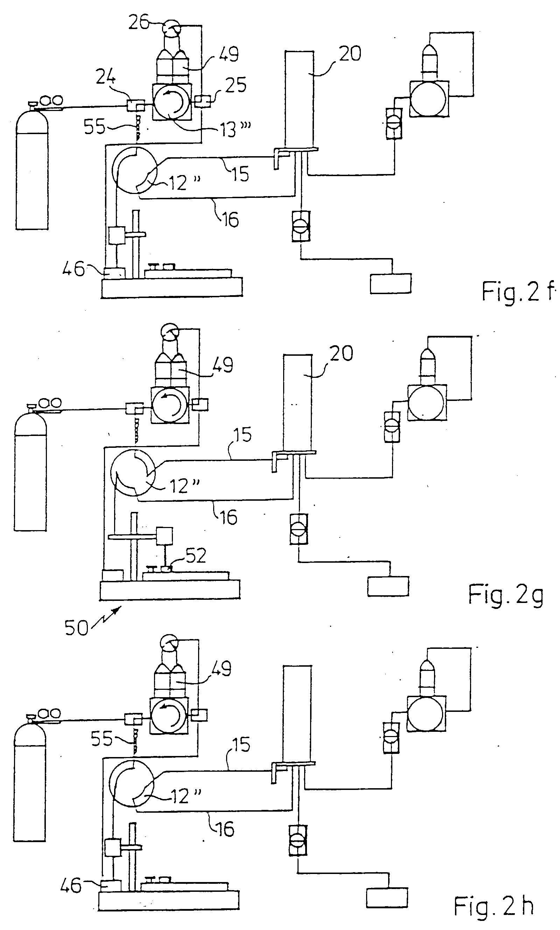

Die Figuren 2 a) bis h) zeigen eine mögliche Abfolge der Verfahrensschritte im einzelnen, wobei in Fig. 2 a) der Übersichtlickeit halber alle an den verschiedenen Verfahrensschritten beteiligten Komponenten mit Bezugsziffern dargestellt sind.

In einem ersten Schritt (Fig. 2 b)) wird über die Inertgaszuführung 14 und ein Ventil 24 trockenes Gas durch die Zulaufleitung 15, den Probenpfad im Probenkopf 20 und die Ablaßleitung 16 in den Entsorgungsbehälter 46 geleitet. Damit wird das Leitungssystem für die Probenflüssigkeit 1 getrocknet und für die nächste Messung vorbereitet. Gleichzeitig wird in diesem ersten Schritt frische Eichflüssigkeit 2 aus dem Vorratsbehälter 42 mit Hilfe der Pumpe 13'' über ein Sperrventil 27 und die Zulaufleitung 17 in den Probenkopf 20 gefördert, während über die Ablaßleitung 18 und ein geöffnetes Ventil 28 im Probenkopf 20 befindliche alte Eichflüssigkeit 2 dem Sammelbehälter 47 zugeführt wird. Danach werden die Ventile 27 und 28 geschlossen und erst bei Bedarf, unter Umständen erst nach sehr vielen NMR-Messungen von Flüssigkeitsproben wieder geöffnet, um frische Eichflüssigkeit 2 in den Probenkopf 20 einzuführen.

Fig. 2 c) zeigt in einem zweiten Schritt das Laden von Probenflüssigkeit 1 aus einem standardisierten Probenbehälter 51 in einer kombinierten Einrichtung 50, die unter anderem einen Autosampler und einen Fraktionssammler enthält. Dabei wird durch die Pumpe 13''' über das Mehrwegeventil 12" Probenflüssigkeit 1 aus dem Probenbehälter 51 in eine Probenschleife 55 gefördert, in welcher die Ankunft der Probenflüssigkeit 1 mit Hilfe eines nicht näher dargestellten Sensors und eines entsprechenden Detektors einer ebenfalls in Fig. 2 nicht dargestellten Steuereinheit gemeldet werden kann. Gleichzeitig sind die Ventile 24 und 25 geöffnet, so daß von der Pumpe 13‴ Flüssigkeitsreste, die sich möglicherweise im Leitungsstück 19 befinden, bis zur Ankunft der Probenflüssigkeit 1 in der Probenschleife 55 in den Entsorgungsbehälter 46 gedrückt werden können.

Sobald die Probenflüssigkeit 1 in der Probenschleife 55 angekommen ist, wird die Pumpe 13''' angehalten und die Verbindung des Leitungssystems mit dem Probenbehälter 51 unterbrochen (Fig. 2 b)).

Im nächsten Schritt (Fig. 2 e)) rotiert die Pumpe 13''' in entgegengesetzter Richtung, wodurch die in der Probenschleife 55 befindliche Probenflüssigkeit mit Hilfe einer aus dem Vorratsbehälter 43 entnommenen Transportflüssigkeit, die über die Ventile 26, 25 und 24 zur Probenschleife 55 gelangt, durch die Zulaufleitung 15 in den Probenkopf 20 transportiert wird. Durch Umschalten des Ventils 24 zwischen den in Fig. 2 d) und Fig. 2 e) dargestellten Schritten könnte auch eine Inertgasblase aus der Inertgaszuführung 14 als Puffer zwischen Probenflüssigkeit 1 und der Transportflüssigkeit 43 in das Leitungssystem eingebracht werden.

In dem in Fig. 2 f) dargestellten Verfahrensschritt sind die Zulaufleitung 15 und die Ablaßleitung 16 für die Probenflüssigkeit 1, die sich nunmehr im Probenkopf 20 befindet, durch eine entsprechende Stellung des Mehrwegeventils 12'' kurzgeschlossen; in diesem Zustand wird die NMR-Messung der Flüssigkeitsprobe durchgeführt. Gleichzeitig wird durch das Ventil 26 aus dem Vorratsbehälter 49 Waschflüssigkeit über das Ventil 25 von der Pumpe 13''' angesaugt und durch das Ventil 24 und die Probenschleife 55 in den Entsorgungsbehälter 46 gedrückt, so daß der Bereich der Probenschleife 55 von Rückständen der Probenflüssigkeit 1 und der Transportflüssigkeit gereinigt wird.

Bei dem in Fig. 2 g) dargestellten Schritt wird die Waschflüssigkeit aus dem Vorratsbehälter 49 durch eine entsprechende Stellung des Mehrwegeventils 12'' in die Zulaufleitung 15 zum Probenkopf 20 umgeleitet, nachdem die NMR-Messung der Probe beendet ist. Gleichzeitig wird die Probenflüssigkeit 1 aus dem Probenkopf 20 durch die Ablaßleitung 16 und das Mehrwegeventil 12'' in einen Fraktionsbehälter 52 geleitet, der sich in der kombinierten Einrichtung 50 mit integriertem Autosampler und Fraktionssammler befindet. Um die verdünnte Phase, die an den Enden der vermessenen Probenflüssigkeit 1 in der Regel existiert, zu minimieren, können jeweils etwa 10 % vom Beginn und vom Ende der Probenfraktion dem Entsorgungsbehälter 46 zugeführt werden. Damit werden dann zwar nur etwa 80 % der Probenflüssigkeit 1 wiedergewonnen, jedoch dafür in der ursprünglichen konzentrierten Form. Dieser Zwischenschritt erübrigt sich, wenn mittels einer Gasblase aus der Inertgaszuführung 14 Probenflüssigkeit 1 von der Transportflüssigkeit räumlich abgetrennt ist. In diesem Falle kann die komplette Probenflüssigkeit 1 im Fraktionsbehälter 52 zurückgewonnen werden.

In dem in Fig. 2 h) dargestellten Reinigungsschritt schließlich wird nochmals Waschflüssigkeit aus dem Vorratsbehälter 49 über die Probenschleife 55 in den Entsorgungsbehälter 46 gepumpt, während die Zulaufleitung 15 und die Ablaßleitung 16 über das Mehrwegeventil 12'' kurzgeschlossen sind. Da sich aus dem vorherigen Schritt (Fig. 2 g)) noch Waschflüssigkeit in der Zulaufleitung 15 befindet, wird bei dem anschließenden Durchblasen des System mit Inertgas (siehe Fig. 2 b)) die Zulaufleitung 15, der Probenpfad im Meßkopf 20 und die Ablaßleitung 16 mit Waschflüssigkeit gereinigt, bevor das Leitungssystem vom dem nachströmenden Inertgas getrocknet wird.

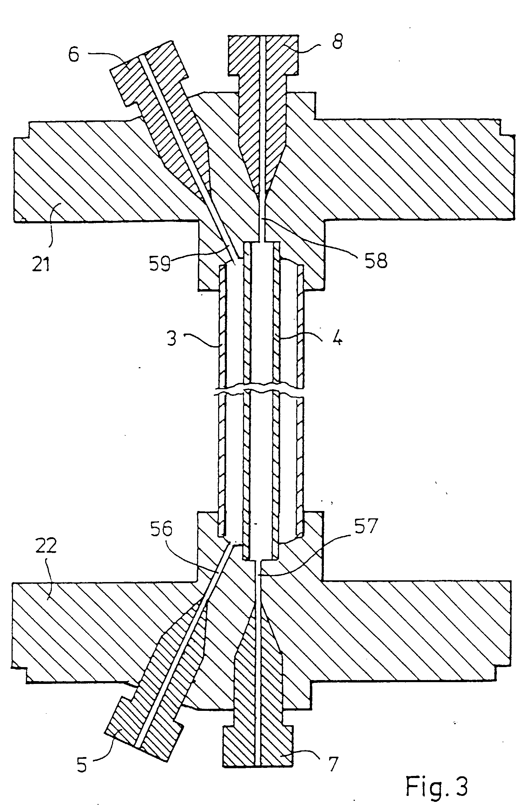

In Fig. 3 sind Details des erfindungswesentlichen Probenkopf-Aufbaus gezeigt. Die Meßzelle besteht aus zwei parallel verlaufenden, ineinander gesteckten, zentrierten Glasröhrchen, wobei das Probenröhrchen 3 das weitere Röhrchen 4 umgibt. Die Glasröhrchen werden von einer oberen Halterung 21 und einer unteren Halterung 22 mechanisch gehalten. In der unteren Halterung 22 ist ein Anschluß 5 für den Zulauf von Probenflüssigkeit 1 in das Probenröhrchen 3 vorgesehen (beispielsweise eingeschraubt oder eingesteckt), der an einem Ende in einen in der unteren Halterung 22 vorgesehenen Injektionskanal 56 mündet, über den Probenflüssigkeit 1 in das Probenröhrchen 3 injiziert werden kann. Über einen Ablaufkanal 59 in der oberen Halterung 21 sowie den Anschluß 6 kann die Probenflüssigkeit 1 das Probenröhrchen 3 wieder verlassen. In gleicher Weise ist für den Zulauf und Ablauf von Eichflüssigkeit 2 zu und von dem weiteren Röhrchen 4 ein Anschluß 7 für den Zulauf, ein Injektionskanal 57 in der unteren Halterung 22, ein Ablaufkanal 58 in der oberen Halterung 21 sowie ein Anschluß 8 für den Ablaß vorgesehen. Die freien Enden der Anschlüsse 5 bis 8 können lösbar mit den entsprechenden Zulauf- und Ablaßleitungen 15 bis 18 verbunden werden.

Während es sich in der Regel für die NMR-Messungen als günstig erweist, wenn das innere, weitere Röhrchen 4 für die Eichflüssigkeit verwendet wird, kann bei speziellen Anwendungsfällen aber auch das äußere Röhrchen 3 mit Eichflüssigkeit 2 befüllt werden, während das innere, weitere Röhrchen 4 mit Probenflüssigkeit 1 befüllt wird. Ein besserer Füllfaktor für die NMR-Messung der Probenflüssigkeit 1 wird jedoch in jedem Falle dann erreicht, wenn die Flüssigkeitsprobe im äußeren und die Eichflüssigkeit 2 mit einer Locksubstanz und/oder Standardflüssigkeit im inneren Röhrchen angeordnet ist.

Für normale Probenvolumina können die Dimensionen der Röhrchen so gewählt werden, daß das Probenröhrchen 3 einen Außendurchmesser von 8 mm und einen Innendurchmesser von 7 mm aufweist, während das weitere Röhrchen 4 einen Außendurchmesser von 1,7 mm und einen Innendurchmesser von 1,3 mm hat. Bei einigen Anwendungsfällen fallen jedoch Mikroproben mit äußerst geringen Volumina an, für die die Röhrchen kleiner dimensioniert werden müssen. In diesem Falle kann der Außendurchmesser des äußeren Röhrchens 3 mit 4 mm und sein Innendurchmesser mit 3,2 mm gewählt werden. Günstigerweise wird man aber die Dimensionierung des inneren Röhrchens 4 bei den Werten eines Innendurchmessers von 1,3 mm und eines Außendurchmessers von 1,7 mm belassen.

Um ein NMR-Spektrometer für unterschiedliche Anwendungsfälle einfach umzurüsten, können mehrere verschiedene Probenköpfe mit bezüglich der Leitungen 15 bis 18 kompatiblen Anschlüssen 5 bis 8, aber unterschiedlichen Durchmessern der Röhrchen 3 und 4 vorgesehen sein. In jedem Falle eignet sich der in Fig. 3 gezeigte Aufbau für die Anwendung von Serien-NMR-Messungen einer Vielzahl von flüssigen Proben.

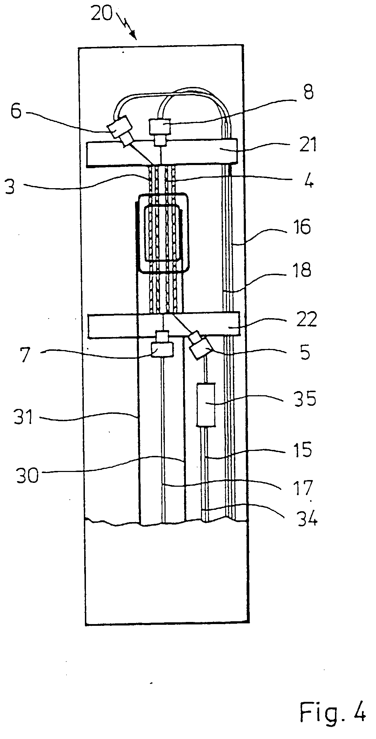

Fig. 4 schließlich zeigt in einer schematischen Seitenansicht den oberen Teil des erfindungsgemäßen Probenkopfes 20 mit den Zulauf- und Ablaßleitungen 15 bis 18 für die Probenflüssigkeit 1 bzw. die Eichflüssigkeit 2 sowie die in den Halterungen 21 und 22 angebrachten Anschlüsse 5 bis 8. Ein Sensor 35 ist in der Zulaufleitung 15 kurz vor deren Verbindung mit dem Anschluß 5 gezeigt. Über eine Sensorleitung 34 kann damit ein Signal bei Ankunft der Probenflüssigkeit 1 im Probenkopf 20 an den in Fig. 1 schematisch dargestellten Rechner 37 weitergeleitet werden, um automatisch eine Spektrenaufnahme zu starten.

Weiterhin zeigt Fig. 4 eine mögliche Anordnung der für die NMR-Messung erforderlichen Hochfrequenz (HF)-Spule 30, die vorzugsweise unmittelbar um das äußere der beiden Röhrchen 3, 4 angeordnet ist, um ein optimales Signal-zu-Rausch-Verhältnis zu erhalten. Normalerweise wird die HF-Spule 30 zur Messung von Protonen oder von Fluorkernen ausgebildet sein.

Außerdem ist eine weitere HF-Spule 31 dargestellt, die beispielsweise für separate Messungen von NMR-Signalen aus der Eichflüssigkeit 2, insbesondere von darin enthaltenen Deuteriumkernen für eine Magnetfeld- oder Frequenzstabilisierung ausgebildet sein kann. Die weitere HF-Spule 31 kann aber auch für eine separate Messung von NMR-Signalen von Heterokernen (alle Kerne außer Protonen und Fluor; z.B. ¹³C) vorgesehen sein.

Bei dem in Fig. 4 gezeigten Ausführungsbeispiel sind die HF-Spulen 30, 31 als Sattelspulen ausgebildet, und das Probenröhrchen 3 ist mit seiner Achse parallel zur Richtung des homogenen statischen Magnetfeldes B₀ ausgerichtet. Bei anderen Ausführungsformen kann das Probenröhrchen 3 aber auch senkrecht zur Richtung des Magnetfeldes ausgerichtet und die HF-Spulen 30, 31 als Solenoidspulen ausgebildet sein.

Besonders vorteilhaft läßt sich das oben beschriebene erfindungsgemäße NMR-Spektrometer für Serienuntersuchungen bei einer großen Anzahl gleichartiger flüssiger Proben, insbesondere für On-Line-Messungen aus Labor-Standardbehältern anwenden, wobei die Reinigung des Leitungssystems nach jedem Meßvorgang relativ einfach ist bzw. automatisiert werden kann. Anwendungsbereiche der erfindungsgemäßen Vorrichtung sind Qualitätskontrollen in der Industrie, schnelle Diagnosen von Krankheitsbildern aus Körperflüssigkeiten für klinische Zwecke und Routinemessungen bei großem Probenanfall in Industrie und Universitäten.

## Patentansprüche

1. Kernspinresonanz (NMR)-Spektrometer zur Messung flüssiger, insbesondere biologischer, vor allem wässriger Proben mit einem Magnetsystem zur Erzeugung eines homogenen, statischen Magnetfeldes B₀ und mit einem Probenkopf, der eine obere und eine untere Halterung, einen Anschluß für eine Zulaufleitung zum Zuführen einer flüssigen Probe in das Spektrometer und einen Anschluß für eine Ablaßleitung zum Ablassen der flüssigen Probe aus dem Spektrometer, ein zwischen der oberen und unteren Halterung angeordnetes, insbesondere zylindrisches Probenröhrchen zur Aufnahme der flüssigen Probe aufweist, wobei das eine Ende des Probenröhrchens mit dem Anschluß für die Zulaufleitung und das andere Ende mit dem Anschluß für die Ablaßleitung verbunden ist, sowie eine das Probenröhrchen umgebende Hochfrequenz (HF)-Spule zum Erzeugen und/oder Detektieren eines senkrecht zur Richtung des statischen Magnetfeldes B₀ gerichteten HF-Magnetfeldes in einem Meßvolumen im Inneren des Probenröhrchens,
dadurch gekennzeichnet,
daß koaxial zum Probenröhrchen (3) ein weiteres, insbesondere ebenfalls zylindrisches Röhrchen (4) zur Aufnahme einer Eichflüssigkeit (2) vorgesehen ist, das an seinem einen Ende mit einem weiteren Anschluß (7) für eine Zulaufleitung (17) zum Zuführen der Eichflüssigkeit (2) in das Spektrometer (10) und an seinem anderen Ende mit einem weiteren Anschluß (8) für eine Ablaßleitung (18) zum Ablassen der Eichflüssigkeit (2) aus dem Spektrometer (10) verbunden ist.

2. NMR-Spektrometer nach Anspruch 1, dadurch gekennzeichnet, daß das Probenröhrchen (3) und das weitere Röhrchen (4) nach Art eines Doppelröhrchens ineinander geschachtelt angeordnet sind.

3. NMR-Spektrometer nach Anspruch 2, dadurch gekennzeichnet, daß die HF-Spule (30) das äußere der beiden Röhrchen (3 oder 4) unmittelbar umgibt.

4. NMR-Spektrometer nach Anspruch 2 oder 3, dadurch gekennzeichnet, daß das weitere Röhrchen (4) innerhalb des Probenröhrchens (3) angeordnet ist.

5. NMR-Spektrometer nach einem der vorhergehenden Ansprüche, dadurch gekennzeichnet, daß die Anschlüsse (5-8) mit den Zulauf-bzw. Ablaßleitungen (15-18) lösbar verbunden sind.

6. NMR-Spektrometer nach einem der vorhergehenden Ansprüche, dadurch gekennzeichnet, daß die HF-Spule (30) zur Messung von Protonen oder von Fluorkernen ausgebildet ist.

7. NMR-Spektrometer nach einem der vorhergehenden Ansprüche, dadurch gekennzeichnet, daß mindestens eine weitere HF-Spule (31) vorgesehen ist.

8. NMR-Spektrometer nach Anspruch 7, dadurch gekennzeichnet, daß die weitere HF-Spule (31) für separate Messungen von NMR-Signalen aus der Eichflüssigkeit (2), insbesondere von darin enthaltenen Deuteriumkernen ausgebildet ist.

9. NMR-Spektrometer nach Anspruch 7, dadurch gekennzeichnet, daß die weitere HF-Spule (31) für die separate Anregung von Heterokernen ausgebildet ist.

10. NMR-Spektrometer nach einem der vorhergehenden Ansprüchen, dadurch gekennzeichnet, daß das Probenröhrchen (3) mit seiner Achse parallel zur Richtung des homogenen statischen Magnetfeldes B₀ ausgerichtet ist und daß die HF-Spule(n) (30, 31) als Sattelspule(n) ausgebildet ist bzw. sind.

11. NMR-Spektrometer nach einem der Ansprüche 1 bis 9, dadurch gekennzeichnet, daß das Probenröhrchen (3) mit seiner Achse senkrecht zur Richtung des homogenen statischen Magnetfeldes B₀ ausgerichtet ist und daß die HF-Spule(n) (30, 31) als Solenoidspule(n) ausgebildet ist bzw. sind.

12. NMR-Spektrometer nach einem der vorhergehenden Ansprüche, dadurch gekennzeichnet, daß mindestens zwei verschiedene Probenköpfe (20) mit bezüglich der Leitungen (15-18) kompatiblen Anschlüssen (5-8) vorgesehen sind.

13. NMR-Spektrometer nach Anspruch 12, dadurch gekennzeichnet, daß die Durchmesser der Probenröhrchen (3) und auch die Durchmesser der weiteren Röhrchen (4) bei verschiedenen Probenköpfen (20) unterschiedlich sind.

14. NMR-Spektrometer nach einem der vorhergehenden Ansprüche, dadurch gekennzeichnet, daß eine Einrichtung (11) zur automatischen Entnahme von Probenflüssigkeit (1) aus einem Standardprobefläschchen (51) und Zuführung und Injektion der entnommenen Probenflüssigkeit (1) in das Probenröhrchen (3) vorgesehen ist.

15. NMR-Spektrometer nach einem der vorhergehenden Ansprüche, dadurch gekennzeichnet, daß am oder im Probenkopf (20) ein beispielsweise optischer oder elektrischer Sensor (35) zur Erkennung der Ankunft der Probenflüssigkeit (1) im Probenkopf (20) vorgesehen ist.

16. NMR-Spektrometer nach einem der vorhergehenden Ansprüche, dadurch gekennzeichnet, daß zumindest in den Ablaßleitungen (16, 18) ein oder mehrere Mehrwegeventile (12, 12', 12") vorgesehen sind.

17. NMR-Spektrometer nach Anspruch 16, dadurch gekennzeichnet, daß ein Fraktionssammler (45) und mindestens ein Entsorgungsbehälter (46) vorgesehen sind, in die alternativ aus einem Mehrwegeventil (12, 12', 12'') kommende Ablaßleitungen münden.

18. NMR-Spektrometer nach einem der vorhergehenden Ansprüche, dadurch gekennzeichnet, daß eine, insbesondere an die Eigenschaften der Probenflüssigkeit (1) angepaßte, Transportflüssigkeit, beispielsweise Wasser, isotonische Lösung etc., zur Förderung der Probenflüssigkeit in den Zulauf- und Ablaßleitungen vorgesehen ist.

19. NMR-Spektrometer nach einem der vorhergehenden Ansprüche, dadurch gekennzeichnet, daß eine Einrichtung (14) zum Zuführen von Inertgas in die Zulauf- und/oder Ablaßleitungen vorgesehen ist.

20. NMR-Spektrometer nach den Ansprüchen 18 und 19, dadurch gekennzeichnet, daß die Einrichtung (14) zum Zuführen von Inertgas so gestaltet ist, daß eine Gasblase zwischen der Probenflüssigkeit (1) und der Transportflüssigkeit erzeugt werden kann.

21. NMR-Spektrometer nach einem der vorhergehenden Ansprüche, dadurch gekennzeichnet, daß eine Einrichtung zum Zuführen von Waschflüssigkeit in die Zulauf- und Ablaßleitungen vorgesehen ist.

22. NMR-Spektrometer nach einem der vorhergehenden Ansprüche, dadurch gekennzeichnet, daß ein Prozessor, vorzugsweise ein PC (37), zur Steuerung der automatisch oder halbautomatisch ablaufenden Flüssigkeitstransportvorgänge vorgesehen ist.

23. Verfahren zum Betrieb eines NMR-Spektrometers nach einem der vorhergehenden Ansprüche, dadurch gekennzeichnet, daß zunächst die Eichflüssigkeit (2) in das weitere Röhrchen (4) injiziert, deren NMR-Signale gemessen und anschließend, vorzugsweise automatisch rechnergesteuert, folgende Schritte ausgeführt werden:
(a) Abzug einer Probenflüssigkeit (1) aus einem Probengeber (11, 51);
(b) Transport der Probenflüssigkeit (1) zum Probenkopf (20);
(c) Injektion der Probenflüssigkeit (1) in das Probenröhrchen (3);
(d) Messung von NMR-Signalen der Probenflüssigkeit (1);
(e) ggf. Spülen zumindest eines Teils der Zulauf- und Ablaßleitung (15, 16) mit einer Waschflüssigkeit gleichzeitig mit Schritt (d);
(f) Ablassen der Probenflüssigkeit (1) aus dem Probenkopf (20), vorzugsweise in einen Fraktionssammler (45);
(g) ggf. Spülen des in Schritt (e) nicht gespülten Teils der Zulauf- und Ablaßleitungen sowie des Probenröhrchens (3) mit der Waschflüssigkeit;
(h) ggf. Trocknen der Leitungen mit Inertgas;
(i) Wiederholung der Schritte (a) bis (h) mit einer anderen Probenflüssigkeit (1).

## Claims

1. Nuclear magnetic resonance (NMR) spectrometer for the measurement of fluid, in particular biological and primarily aqueous samples, with a magnetic system for the production of a homogeneous static magnetic field B₀ and with a probe head which exhibits an upper and a lower support, a connector for a feed conduit for the introduction of a fluid sample into the spectrometer, a connector for a drain conduit to drain the fluid sample out of the spectrometer, and an, in particular cylindrical, sample tube arranged between the upper and the lower supports for the acceptance of the liquid sample, whereby the one end of the sample tube is connected to the connector for the feed conduit and the other end to the connector for the drain conduit, as well as a radio frequency (RF)-coil surrounding the sample tube for the production and/or detection of an RF-magnetic field directed perpendicular to the direction of the static magnetic field B₀ in a measurement volume within the sample tube,
characterized in that an additional, in particular a likewise cylindrically shaped tube (4) is provided coaxially to the sample tube (3) for the acceptance of a calibration fluid (2), which is connected on one end to an additional connector (7) for a feed conduit (17) for the introduction of the calibration liquid (2) into the spectrometer (10) and on its other end to an additional connector (8) for a drain conduit (18) to drain the calibration fluid (2) out of the spectrometer (10).

2. NMR spectrometer according to claim 1, characterized in that the sample tube (3) and the additional tube (4) are arranged and nested within another in the fashion of a double tube.

3. NMR spectrometer according to claim 2, characterized in that the RF-coil (30) surrounds, in close proximity, the outer portion of both tubes (3 or 4).

4. NMR spectrometer according to claim 2 or 3, characterized in that the additional tube (4) is arranged within the sample tube (3).

5. NMR spectrometer according to one of the preceding claims, characterized in that the connectors (5-8) are connected in a disconnectable fashion to the feed or drain conduits (15-18), respectively.

6. NMR spectrometer according to one of the preceding claims, characterized in that the RF-coil (30) is configured for the measurement of protons or fluorine nuclei.

7. NMR spectrometer according to one of the preceding claims, characterized in that at least one additional RF-coil (31) is provided for.

8. NMR spectrometer according to claim 7, characterized in that the additional RF coil (31) is configured for separate measurements of NMR signals from the calibration fluid (2), in particular, from the deuterium nuclei contained therein.

9. NMR spectrometer according to claim 7, characterized in that the additional RF-coil (31) is configured for the separate excitation of hetero-nuclei.

10. NMR spectrometer according to one of the preceding claims, characterized in that the sample tube (3) is directed with its axis parallel to the direction of the homogeneous static magnetic field B₀ and that the RF-coil(s) (30, 31) is or are configured as saddle coil(s).

11. NMR spectrometer according to one of the claims 1 through 9, characterized in that the sample tube (3) is directed with its axis perpendicular to the direction of the homogeneous static magnetic field B₀ and that the RF coil(s) (30, 31) is or are configured as solenoid coil(s).

12. NMR spectrometer according to one of the preceding claims, characterized in that at least two differing probe heads (20) are provided for with connectors (5-8) which are compatible with the conduits (15-18).

13. NMR spectrometer according to claim 12, characterized in that the diameter of the sample tube (3) as well as the diameter of the additional tubes (4) differ for differing probe heads (20).

14. NMR spectrometer according to one of the preceding claims, characterized in that a device (11) is provided for the automatic removal of sample fluid (1) from a standard sample bottle (51) and for the introduction and injection of the removed sample fluid (1) into the sample tube (3).

15. NMR spectrometer according to one of the preceding claims, characterized in that a, for example, optical or electrical sensor (35) is provided for on or in the probe head (20) for the recognition of the arrival of the sample fluid (1) in the probe head (20).

16. NMR spectrometer according to one of the preceding claims, characterized in that, at least in the drain conduits (16, 18), one or more multiple-way valves (12, 12', 12") are provided for.

17. NMR-spectrometer according to claim 16, characterized in that a fraction collector (45) and at least one waste container (46) are provided for into which drain conduits, alternatively emanating out of a multiple-way valve (12, 12', 12"), feed.

18. NMR spectrometer according to one of the preceding claims, characterized in that a transport fluid, in particular one which is adapted to the properties of the sample fluid (1), by way of example water, isotonic solution etc., is provided for the transport of the sample fluid into the feed and drain conduits.

19. NMR spectrometer according to one of the preceding claims, characterized in that a device (14) is provided for the introduction of inert gas into the feed and/or drain conduits.

20. NMR spectrometer according to claims 18 and 19, characterized in that the device (14) for the introduction of inert gas is configured such that a gas bubble can be produced between the sample fluid (1) and the transport fluid.

21. NMR spectrometer according to one of the preceding claims, characterized in that a device is provided for the introduction of washing fluid into the feed and drain conduits.

22. NMR spectrometer according to one of the preceding claims, characterized in that a processor, preferentially a personal computer (37) is provided for the control of the automatic or semi-automatic fluid transport procedures.

23. Method for the operation of an NMR spectrometer according to one of the preceding claims, characterized in that, initially, the calibration fluid (2) is injected into the additional tube (4), its NMR signals are measured and subsequently the following steps are carried out preferentially in an automatic computer controlled fashion:
(a) extracting a sample fluid (1) from a sample supplier (11, 51);
(b) transporting the sample fluid (1) to the probe head (20);
(c) injecting the sample fluid (1) into the sample tube (3);
(d) measuring NMR signals from the sample fluid (1);
(e) if appropriate, rinsing at least a portion of the feed and drain conduits (15, 16) with a washing fluid simultaneously with step (d);
(f) draining the sample fluid (1) out of the probe head (20), preferentially into a fraction collector (45);
(g) if appropriate, rinsing that portion of the feed and drain conduits as well as the sample tube (3) with the washing fluid which was not rinsed in step (e);
(h) if appropriate, drying the conduits with inert gas;
(i) repeating the steps (a) through (h) with a different sample fluid (1).

## Revendications

1. Spectromètre de résonance de spin nucléaire (RMN) pour la mesure d'échantillons liquides, notamment biologiques et principalement aqueux, avec un système magnétique pour produire un champ magnétique statique homogène B₀, et avec une tête d'échantillonnage qui présente un support supérieur et un support inférieur, un branchement pour une conduite d'alimentation pour apporter un échantillon liquide dans le spectromètre et un branchement pour une conduite d'évacuation pour évacuer l'échantillon liquide du spectromètre, une éprouvette notamment cylindrique, disposée entre le support supérieur et le support inférieur et destinée à recevoir l'échantillon liquide, une extrémité de l'éprouvette étant reliée au branchement pour la conduite d'alimentation et l'autre extrémité au branchement pour la conduite d'évacuation, ainsi qu'une bobine à haute fréquence (HF) entourant l'éprouvette et destinée à produire et/ou détecter un champ magnétique à haute fréquence (HF), orienté perpendiculairement à la direction du champ magnétique statique B₀, dans un volume de mesure à l'intérieur de l'éprouvette, **caractérisé** en ce qu'un autre petit tube (4), notamment également cylindrique, est prévu coaxialement à l'éprouvette (3) pour recevoir un liquide étalon (2), tube qui est relié par une extrémité à un branchement supplémentaire (7) pour une conduite d'alimentation (17) pour apporter le liquide étalon (2) dans le spectromètre (10), et par son autre extrémité à un autre branchement (8) pour une conduite d'évacuation (18) pour évacuer le liquide étalon (2) du spectromètre (10).

2. Spectromètre RMN selon la revendication 1, **caractérisé** en ce que l'éprouvette (3) et l'autre petit tube (4) sont imbriqués l'un dans l'autre à la manière d'une éprouvette double.

3. Spectromètre RMN selon la revendication 2, **caractérisé** en ce que la bobine HF (30) entoure directement le petit tube extérieur (3 ou 4).

4. Spectromètre RMN selon la revendication 2 ou 3, **caractérisé** en ce que l'autre petit tube (4) est disposé à l'intérieur de l'éprouvette (3).

5. Spectromètre RMN selon une des revendications précédentes, **caractérisé** en ce que les branchements (5 à 8) sont reliés de façon détachable aux conduites respectives d'alimentation et d'évacuation (15 à 18).

6. Spectromètre RMN selon une des revendications précédentes, **caractérisé** en ce que la bobine HF (30) est conçue pour la mesure de protons ou de noyaux de fluor.

7. Spectromètre RMN selon une des revendications précédentes, **caractérisé** en ce qu'il est prévu au moins une autre bobine HF (31).

8. Spectromètre RMN selon la revendication 7, **caractérisé** en ce que l'autre bobine HF (31) est conçue pour des mesures séparées de signaux RMN provenant du liquide étalon (2), notamment de noyaux de deutérium contenus dans ce dernier.

9. Spectromètre RMN selon la revendication 7, **caractérisé** en ce que l'autre bobine HF (31) est conçue pour l'excitation séparée d'hétéroatomes.

10. Spectromètre RMN selon une des revendications précédentes, **caractérisé** en ce que l'axe de l'éprouvette (3) est orienté parallèlement à la direction du champ magnétique statique homogène B₀, et en ce que la ou les bobines HF (30, 31) sont réalisées sous la forme de bobines en sellette.

11. Spectromètre RMN selon une des revendications 1 à 9, **caractérisé** en ce que l'axe de l'éprouvette (3) est orienté perpendiculairement à la direction du champ magnétique statique homogène B₀, et en ce que la ou les bobines HF (30, 31) sont réalisées sous la forme de bobines à solénoïde.

12. Spectromètre RMN selon une des revendications précédentes, **caractérisé** en ce qu'il est prévu au moins deux têtes d'échantillonnage (20) différentes, avec des branchements (5 à 8) compatibles avec les conduites (15 à 18).

13. Spectromètre RMN selon la revendication 12, **caractérisé** en ce que les diamètres des éprouvettes (3) ainsi que des autres petits tubes (4) de têtes d'échantillonnage différentes (20) sont différents.

14. Spectromètre RMN selon une des revendications précédentes, **caractérisé** en ce qu'il est prévu un dispositif (11) pour le prélèvement automatique d'un échantillon de liquide (1) d'une bouteille d'échantillonnage standard (51), et l'apport et l'injection dans l'éprouvette (3) de l'échantillon de liquide prélevé (1).

15. Spectromètre RMN selon une des revendications précédentes, **caractérisé** en ce qu'un capteur (35), optique ou électrique par exemple, est prévu sur ou dans la tête d'échantillonnage (20) pour reconnaître l'arrivée de l'échantillon de liquide (1) dans la tête d'échantillonnage (20).

16. Spectromètre RMN selon une des revendications précédentes, **caractérisé** en ce qu'un ou plusieurs distributeurs à plusieurs voies (12, 12', 12") sont prévus au moins dans les conduites d'évacuation (16, 18).

17. Spectromètre RMN selon la revendication 16, **caractérisé** en ce qu'il est prévu un collecteur de fraction (45) et au moins un récipient d'élimination (46), dans lesquels débouchent alternativement les conduites d'évacuation provenant d'un distnbuteur à plusieurs voies (12, 12', 12").

18. Spectromètre RMN selon une des revendications précédentes, **caractérisé** en ce qu'il est prévu un liquide de transport, notamment adapté aux propriétés de l'échantillon de liquide (1), par exemple de l'eau, une solution isotonique, etc., pour transporter l'échantillon de liquide dans les conduites d'alimentation et d'évacuation.

19. Spectromètre RMN selon une des revendications précédentes, **caractérisé** en ce qu'il est prévu un dispositif (14) pour apporter du gaz inerte dans les conduites d'alimentation et/ou d'évacuation.

20. Spectromètre RMN selon la revendication 18 ou 19, **caractérisé** en ce que le dispositif (14) pour apporter du gaz inerte est conçu de telle sorte qu'une bulle de gaz peut être produite entre l'échantillon de liquide (1) et le liquide de transport.

21. Spectromètre RMN selon une des revendications précédentes, **caractérisé** en ce qu'il est prévu un dispositif pour apporter du liquide de nettoyage dans les conduites d'alimentation et d'évacuation.

22. Spectromètre RMN selon une des revendications précédentes, **caractérisé** en ce qu'il est prévu un processeur, de préférence un ordinateur personnel (37), pour la commande des opérations de transport de liquide à déroulement automatique ou semi-automatique.

23. Procédé d'exploitation d'un spectromètre RMN selon une des revendications précédentes, **caractérisé** en ce qu'on injecte d'abord dans l'autre petit tube (4) le liquide étalon (2), dont les signaux RMN sont mesurés, puis on accomplit, de préférence sous commande automatique par ordinateur, les étapes suivantes :
(a) extraction d'un échantillon de liquide (1) d'un fournisseur d'échantillon ;
(b) transport de l'échantillon de liquide (1) vers la tête d'échantillonnage (20) ;
(c) injection de l'échantillon de liquide (1) dans l'éprouvette (3) ;
(d) mesure des signaux RMN de l'échantillon de liquide (1) ;
(e) éventuellement, en même temps que l'étape (d), rinçage d'au moins une partie de la conduite d'alimentation (15) et de la conduite d'évacuation (16) avec un liquide de nettoyage ;
(f) évacuation de l'échantillon de liquide (1) de la tête d'échantillonnage (20), de préférence dans un collecteur de fraction (45) ;
(g) éventuellement, rinçage avec le liquide de nettoyage de la partie des conduites d'alimentation et d'évacuation non rincée à l'étape (e), ainsi que de l'éprouvette (3) ;
(h) éventuellement, séchage des conduites au gaz inerte ;
(i) répétition des étapes (a) à (h) avec un autre échantillon de liquide (1).
